(19) Europäisches Patentamt
European Patent Office
Office européen des brevets

(11) **EP 1 857 574 B1**

(12) **EUROPÄISCHE PATENTSCHRIFT**

(45) Veröffentlichungstag und Bekanntmachung des Hinweises auf die Patenterteilung:
**16.02.2011 Patentblatt 2011/07**

(51) Int Cl.:
***C30B 11/00*** *(2006.01)*

(21) Anmeldenummer: **07104930.8**

(22) Anmeldetag: **26.03.2007**

(54) **Vorrichtung und Verfahren zur Herstellung von kristallinen Materialien**

Device and method for growing crystals

Dispositif et procédé de croissance de cristaux

(84) Benannte Vertragsstaaten:
**AT BE BG CH CY CZ DE DK EE ES FI FR GB GR HU IE IS IT LI LT LU LV MC MT NL PL PT RO SE SI SK TR**
Benannte Erstreckungsstaaten:
**AL BA HR MK RS**

(30) Priorität: **12.04.2006 DE 102006017621**

(43) Veröffentlichungstag der Anmeldung:
**21.11.2007 Patentblatt 2007/47**

(73) Patentinhaber: **Schott AG**
**55122 Mainz (DE)**

(72) Erfinder:
• **Müller, Matthias**
**07745 Jena (DE)**

• **Finkbeiner, Markus**
**75196 Remchingen (DE)**
• **Sahr, Uwe**
**90411 Nürnberg (DE)**
• **Schwirtlich, Ingo**
**63897 Miltenberg (DE)**
• **Clauss, Michael**
**65719 Hofheim (DE)**

(74) Vertreter: **2K Patentanwälte Blasberg Kewitz & Reichel**
**Partnerschaft**
**Corneliusstraße 18**
**60325 Frankfurt am Main (DE)**

(56) Entgegenhaltungen:
**EP-A- 1 072 696     JP-A- 5 043 385**
**JP-A- 2004 299 968**

## Beschreibung

### Gebiet der Erfindung

Die vorliegende Erfindung betrifft allgemein die Herstellung von vergleichsweise großen ein- oder multikristallinen Materialrohlingen nach dem Vertical-Gradiant-Freeze-Verfahren (nachfolgend auch VGF-VerFahren genannt), insbesondere von multikristallinem Silizium für Anwendungen in der Fotovoltaik, von einkristallinen Fluoridkristallen und einkristallinen Germaniumkristallen.

### Hintergrund der Erfindung

Solarzellen sollen einen möglichst hohen Wirkungsgrad bei der Umwandlung von Solarstrahlung in Strom aufweisen. Dieser ist von mehreren Faktoren abhängig, wie unter anderem von der Reinheit des Ausgangsmateriales, dem Eindringen von Verunreinigungen während der Kristallisation von den Berührungsflächen des Kristalls mit dem Tiegel in das Kristallinnere, dem Eindringen von Sauerstoff und Kohlenstoff aus der umgebenden Atmosphäre in das Kristallinnere und auch von der Wachstumsrichtung der einzelnen Kristallkörner.

Allen bekannten Herstellungsvcrfahren, bei denen eine große Menge sclunclzflüssigen Siliziums zu einem Ingot erstarrt, ist gemeinsam, dass der hristallschmelze an ihrem Boden Warme entzogen wird und so ein Kristall von unten nach oben wächst. Aufgrund der typischerweise schnell verlaufenden Erstarrung und des Verzichts auf einen Keimkristall wächst der Kristall nicht als Einkristall sondern multikristallin. Es entsteht ein Block, der aus vielen Kristallkörnern besteht, von denen ein jedes Korn in der Richtung des lokal existierenden Temperaturgradienten wächst.

Wenn nun im schmelzflüssigen Silizium-Volumen die Isothermen des Temperaturfeldes nicht eben und nicht parallel zur Grundfläche des Tiegel, d.h. horizontal, verlaufen, wird sich keine ebene Phasengrenze ausbilden und werden die einzelnen Körner nicht parallel zueinander und senkrecht von unten nach oben wachsen. Dies geht einher mit der Ausbildung linienartiger Kristallbaufehler auch innerhalb der einkristallinen Bereiche. Diese unerwünschten Kristallbaufehler können durch Anätzcn polierter fläche (z.B. an Siliziumwafern) als Ätzgruben sichtbar gemacht werden. Eine wie vorstehend beschrieben erhöhte Anzahl von linienartigen Kristallbaufehlem führt somit zu einer erhöhten Ätzgrubendichte.

Es ist eine bereits lange bekannte Anforderung, die von mehreren Faktoren beeinflussbare Ätzgrubendichte unter anderem durch Einstellung einer ebenen Phasengrenze zu minimieren. Die Ätzgrubendichte ist daher auch ein Maß dafür, wie gut es gelungen ist, durch die ebene Phasengrenze ein säulenartiges Wachstum der Si-Körner zu gewährleisten. Seit Etablierung des HEM-Verfahrens (Heat-Exchange-Method) zu einem ersten für eine Massenproduktion tauglichen Verfahren wird versucht, den Nachteil einer nahezu punktförmigen Wärmesenke am Tiegelboden (wie z.B. aus der US 4256530 zu entnehmen) zu vermeiden und im schmelzflüssigen Silizium einen senkrechten Wärmefluss von oben nach unten zu realisieren.

Es gibt daher verschiedene Lösungen, die als einen ersten Schritt darauf abzielen, eine Wärmesenke zu schaffen, die sich über die gesamte Fläche des Tiegelbodens erstreckt (vgl. beispielsweise EP 0631 832, EP 0996516, DE 19855061). Die vorliegende Erfindung geht davon aus, dass eine solche flächige Wärmesenke vorgesehen ist.

Um Solarzellen möglichst kostengünstig herzustellen, besteht eine weitere Forderung darin, dass möglichst der gesamte Silizium-Ingot zur weiteren Verarbeitung ausgenutzt werden kann. Der Herstellungsprozess unterliegt jedoch Beschränkungen. Diese rühren einerseits von dem Eindiffundieren von Verunreinigungen aus der Tiegelwand in die Siliziumschmelze her und andererseits führt die Segregation zu einer Ansammlung von Verunreinigungen an der Oberseite des entstehenden Silizium-Ingots, so dass regelmäßig Ränder des Silizium-ingots abgetrennt werden müssen. Eine weitere Beschränkung ist durch die im Allgemeinen rechteckförmige Grundform von Solarzelle vorgegeben. Dies bedingt ein Zuschneiden des Silizium-Ingots auf den gewünschten Querschnitt. Dabei ist es wünschenswert, dass der Verschnitt möglichst gering ist.

Die Herstellung von multikristallinem Silizium aus einer Schmelze ist vergleichsweise energieintensiv. Eine weitere Forderung besteht deshalb darin, dass das Volumen des Schmelzofens möglichst optimal ausgenutzt und effizient thermisch isoliert wird. Aus Platzgründen sollte die Grundfläche des Schmelztiegels einen möglichst großen Teil der Grundfläche des Schmelzofens einnehmen.

Wegen der großen wirtschaftlichen Bedeutung der Herstellung von Silizium als Ausgangsmaterial für die Herstellung von Halbleitern und Halbleiter-Bauelementen sind aus dem Stand der Technik eine Vielzahl unterschiedlicher Lösungsansätze zum Züchten von Silizium-Einkristallen oder multikristallinem Silizium bekannt. So offenbart US 4.256,530 ein Verfahren zum Züchten eines Silizium-Einkristalls, bei dem ein Schmelztiegel mit zweilagigen Wänden ausgebildet ist, so dass die Silizium-Schmelze nicht unmittelbar mit Graphit bzw. elementarem Kohlenstoff in Kontakt gelangt, der ansonsten rasch in die Siliziumschmetze eindiffundieren würde.

Um eine möglichst geringe Versetzungsdichte in dem Kristall zu erhalten, ist bei der Kristallzüchtung auf eine möglichst ebene, quer zur Kristallisationsrichtung verlaufende Phasengrenze zwischen fest und flüssig zu achten. Diese Zielsetzung erfordert es, die radiale Abstrahlung von Wärme möglichst gering zu halten. Gemäß der WO 01/64975 A2 wird zur Erzeugung einer ebenen Phasengrenze zwischen dem Boden eines Schmelzgefäßes und dessen oberer Öffnung ein senkrecht verlaufender axialer Temperaturgradient angeregt und werden Maßnahmen ergriffen, um einen durch die Seitenwände des Schmelzgefäßes verlaufenden Wärmeabfluss zu vermeiden. Zu diesem Zweck sind sämtliche Heizelemente in eine das Schmelzgefäß umgebende Umhüllung aus einem Isolationsmaterial mit eingeschlossen, um auf diese Weise einen ungewollten und unkontrollierten Wärmefluss zu vermeiden. Zu diesem Zweck ist zwischen Mantelheizer und dem Tiegel eine Umhüllung aus einem Isolationsmaterial angeordnet, um auf diese zusätzliche Weise einen radialen Wärmefluss zu vermeiden. Dadurch wird eine Dominanz des durch Decken- und Bodenheizer erzeugten axialen Temperaturprofils erreicht.

EP 1 147 248 B1 offenbart eine Vorrichtung zur Herstellung eines Einkristalls durch Züchten aus einer Schmelze, wobei der Ofen rotationssymmetrisch ausgebildet ist und wobei um das Schmelzgefäß herum eine, in Längsrichtung desselben betrachtet, keilförmige thermische Isolation vorgesehen ist, die eine von dem Deckelheizer zu dem Bodenheizer abnehmende isolationswirkung aufweist. Wärmeverluste nahe dem Bodenheizer sind somit größer als nahe dem Deckelheizer. Auf diese Weise wird ein Temperaturgradient in Längsrichtung des Schmelzgefäßes unterstützt, der durch eine unterschiedliche Temperatur von Deckelheizer und Bodenheizer vorgegeben wird. Die thermische Isolation schränkt auch einen Wärmefluss in Radialrichtung des Schmelzgefäßes erheblich ein, was zur Ausbildung von flachen Phasengrenzen führt.

DE 102 39 104 A1 offenbart einen Kristallzüchtungsofen für ein VGF-Verfahren oder Vertical-Bridgman-Verfahren. Um das Schmelzgefäß herum sind koaxial und vertikal übereinander zwei Mantelheizer angeordnet. Ferner sind Messeinrichtungen zur Bestimmung von radialen Temperaturdifferenzen im Raum zwischen den Mantelheizern und dem Schmelzgefäß vorgesehen. Eine Regelung stellt die Heizleistung der Mantelheizer so ein, dass die in Radialrichtung gemessene Temperaturdifferenz zu Null wird. Auf diese Weise werden ebene Phasengrenzflächen eingestellt, was zur Herstellung von hochwertigen, versetzungsarmen Silizium-Einkristallen führt.

Gemäß dem Stand der Technik sind die Heizer und die äußere Kontur einer Kristallisationsanlage für multikristallines Silizium üblicherweise rotationssymmetrisch ausgebildet, d.h. diese besitzen ein kreisförmiges Profil. Da der üblicherweise quadratische Tiegel von diesem kreisförmigen Heizer umgeben ist, kommt es zum Problem der Eckenüberhitzung. Diese führt zu thermischen Spannungen, zu darauf zurückzuführenden Ekkenabplatzungen und demzufolge zu einem vergleichsweise großen Verschnitt, was es zu vermeiden gilt. Bei der Herstellung von großen fluoridischen Einkristallen sowie von Germaniumkristallen werden typischerweise runde Kristalle in runden Tiegeln hergestellt. Die Tiegel werden von runden Heizern umgeben, welche zwischen oberem und unterem Bereich keine Unterschiede in der Warmestrahlung aufweisen.

JP 2004 299968 A offenbart ein flächiges Graphit-Heizelement, mit mäanderförmigem Verlauf der Heizstege. Das Graphit-Heizelement ist hohlzylindrisch ausgebildet und konzentrisch zum ebenfalls runden Schmelztiegel angeordnet. Der mäanderförmige Verlauf wird durch alternierende Ausbildung von axialen Längsschlitzen in einem Graphit-Zylinder bewirkt. Eine umlaufende Aussparung ist zumindest am oberen Rand des Graphit-Heizelements ausgebildet, um für eine homogene Heizleistung zu sorgen. Diese Anordnung ist nicht geeignet zur Herstellung von vieleckigen Ingots.

JP 05 043385 A offenbart ein flächiges Graphit-Heizelement zur Herstellung eines Silizium-Einkristalls. Das flächige Heizelement weist einen mäanderförmigen Verlauf der Heizstege auf. In den Heizstegen sind an anderen Stellen als den Umkehrbereichen des mäanderförmigen Verlaufs Durchgangsbohrungen an vorbestimmten Positionen ausgebildet, um so die ausgebildete Temperaturveneilung zu beeinflussen.

EP 1 072 696 A1 offenbar eine Vorrichtung und ein Verfahren zum Herstellen von gerichtet erstarrten Blöcken mit rechteckförmigem Querschnitt. Durch Verfahren eines Kammeroberteils an mindestens einer Umfangsseite der Vorrichtung kann der Schmelztiegel freigelegt werden, was eine rasche Chargierung und Dechargierung ermöglicht.

## Zusammenfassung der Erfindung

Aufgabe der vorliegenden Erfindung ist es somit, eine Vorrichtung und ein Verfahren zur kostengünstigen Herstellung von hochwertigem, versetzungsarmem ein- oder multikristallinen Materialrohlingen nach dem VGF-Verfahren bereitzustellen, insbesondere von multikristallinem Silizium, großen fluoridischen Einkristallen oder von Germaniumeinkristallen.

Diese und weitere Aufgaben werden gemäß der vorliegenden Erfindung durch eine Vorrichtung mit den Merkmalen nach Anspruch 1 sowie durch ein Verfahren mit den Merkmalen nach Anspruch 16 gelöst. Weitere vorteilhafte Ausführungsformen sind Gegenstand der rückbezogenen Unteransprüche.

Somit geht die vorliegende Erfindung aus von einer Vorrichtung mit einem feststehenden Tiegel und einer Heizeinrichtung zum Aufschmelzen des in dem Tiegel befindlichen Siliziums. Dabei ist die Heizeinrichtung und/oder eine thermische Isolation der Vorrichtung so ausgelegt, um in dem Tiegel einen Temperaturgradienten in der Längsrichtung auszubilden. Dies erfolgt normalerweise dadurch, dass der Boden des Tiegels auf einer niedrigeren Temperatur gehalten wird als das obere Ende desselben. Ferner weist bei einer solchen Vorrichtung die Heizeinrichtung ein flächiges Heizelement (nachfolgend als "Mantelheizer" bezeichnet) zur Unterdrückung eines Wärmeflusses senkrecht zur Längsrichtung, das heißt horizontal auswärts gerichtet, auf.

Erfindungsgemäß ist der Mantelheizer ein Einzonenheizer, der so ausgelegt, dass seine Heizleistung in der Längsrichtung von dem oberen Ende zu dem unteren Ende hin abnimmt, um zur Aufrechterhaltung des in dem Tiegel ausgebildeten Temperaturgradienten zumindest beizutragen. Mit anderen Worten, durch Variieren der Heizleistung des Mantelheizers in Längsrichtung des Tiegels in stetiger oder diskreter Weise wird die Ausbildung eines vorbestimmten Temperaturgradienten in dem Tiegel zumindest unterstützt. Dieser Temperaturgradient wird in dem Schmelztiegel durch unterschiedliche Temperaturen eines Deckelheizers und einer Bodenheizers in an sich bekannter Weise vorgegeben. Dabei ist die Temperatur des Bodenheizers am Boden des Schmelztiegels niedriger, insbesondere unterhalb der Schmelztemperatur des zu verarbeitenden Siliziums. Zweckmäßig erstreckt sich dabei der Bodenheizer nicht zwangsläufig über die gesamte Grundfläche des Tiegels. Die Ausbildung einer ebenen Phasengrenzen in dem zu kristallisierenden Material, beispielsweise Silizium, ist mit einem sich über die Grundfläche des Tiegels sich erstreckenden Bodenheizer zwar am exaktesten realisierbar, aber eine in der Praxis ausreichend ebene Phasengrenze ist auch noch realisierbar, wenn zwischen Heizer und Tiegel eine Tiegelaufstellplatte angeordnet ist, die es gestattet, auch einen flächenmäßig kleineren Bodenheizer kombiniert mit einer Kühleinrichtung anzuordnen. Erfindfindungsgemäß wird der Temperaturgradient zwischen oben und unten nun durch die in Längsrichtung des Schmelztiegels variierende Heizleistung des Mantelheizers nachgebildet, so dass über den gesamten Querschnitt des Tiegels, insbesondere auch im Bereich der Ecken des vieleckigen Tiegels, eine ebene Phasengrenze zwischen schon auskristallisiertem Silizium und dem noch geschmolzenen Silizium ausgebildet ist, also eine horizontal verlaufende Phasengrenze. Somit ist erfindungsgemäß kein Aufwand für eine thermische Isolation zwischen Tiegel und Mantelheizer erforderlich, weil der den Quarztiegel umschließende Graphittiegel ausreichend ist, um das vom Mantelheizer erzeugte Temperaturprofil ausreichend zu vergleichmäßigen. Ausreichende Vergleichmäßigung heißt dabei insbesondere, dass infolge der hohen thermischen Leitfähigkeit des äußeren Tiegelmaterials Graphit lokale Unterschiede bzgl. der vom Mantelheizer abgestrahlten Wärme ausgeglichen werden. Das sich so in der Graphittiegelwand herausbildende vertikale Temperaturprofil wird durch die Tiegelwand des schwach wärmeleitfähigen Quarztiegels hindurch an die innere Wand des Quarztiegels nahezu unverändert übertragen. An der Kontaktfläche von schmelzflüssigem Silizium und Quarztiegel fällt die Temperatur von oben nach unten monoton und angenähert linear ab. Dadurch kann trotz Wegfall der Schicht aus thermischem Isolationsmaterial eine ebene, horizontale Phasengrenze zwischen dem auskristallisierten Silizium und dem noch geschmolzenen Silizium gewährleistet werden. Dies ermöglicht bei gleichen Außenabmessungen der Kristallisationsanlage einen insgesamt größeren Querschnitt des Tiegels und somit erfindungsgemäß die Bereitstellung von größeren Silizium-Ingots, was in erheblichen Kostenvorteilen resultiert. Der erfindungsgemäße Einzonenmantelheizer mit definiert einstellbarem Temperaturprofil über die Mantelhöhe ist bei der Herstellung von multikristallinem Silizium von besonderem Vorteil, wenn mit Quarztiegeln einer Höhe von mehr als etwa 250 mm, insbesondere mehr als etwa 300 mm und ganz besonders bevorzugt mehr als 350 mm gearbeitet wird. Der Einzonenmantelheizer mit definiert einstellbarem Temperaturprofil über die Mantelhöhe ist bei der Herstellung von Fluorideinkristallen und Germaniumeinkristallen von besonderem Vorteil, wenn Kristalle einer Höhe von mehr als etwa 200 mm hergestellt werden.

Die Heizleistung des Mantelheizers kann erfindungsgemäß durch einfache Maßnahmen, wie beispielsweise Variation des geometrischen Querschnitts des Mantelheizers, geeignet eingestellt werden. Insbesondere kann der Mantelheizer so in einfacher Weise auf die geometriebedingten thermischen Eigenschaften des Tiegels abgestimmt werden.

Bevorzugt weist der Tiegel einen vieleckigen Querschnitt, ganz besonders bevorzugt einen rechteckförmigen oder quadratischen Querschnitt, auf, so dass vieleckige, insbesondere rechteckförmige oder quadratische, Elemente, bevorzugt Silizium-Elemente, mit vorteilhaft geringem Verschnitt aus dem Silizium-Ingot herausgeschnitten werden können. Die erfindungsgemäße Vorrichtung beruht deshalb auf der Abkehr von dem üblichen Konzept, einen rotationssymmetrischen Schmelztiegel zur Herstellung von multikristallinem Silizium zu verwenden. Im Unterschied zum Stand der Technik weist der um den Tiegel angeordnete Heizer dieselbe Kontur auf wie der Tiegel. Ein beispielsweise quadratischer Tiegel ist also von einem quadratischen Heizer umgeben. Auf die übliche Wärmeisolationsschicht zwischen Heizer und Tiegel wird verzichtet.

Gemäß einer weiteren Ausführungsform nimmt die Heizleistung des Einzonenmantelheizers in der Längsrichtung des Tiegels von oben nach unten in Entsprechung zu dem Temperaturgradienten im Zentrum des Tiegels ab. Insbesondere nimmt die Heizleistung des Mantelheizers je Längeneinheit exakt in demselben Verhältnis ab, in dem der Temperaturgradient im Zentrum des Tiegels abnimmt. Durch diese exakte insbesondere proportionale Nachbildung des Temperaturgradienten im Zentrum des Tiegels über den gesamten Umfang desselben, können erfindungsgemäß ebene Phasengrenzen zwischen schon auskristallisiertem Silizium und noch geschmolzenem Silizium über den gesamten Querschnitt des Tiegels in einfacher Weise gewährleistet werden, insbesondere auch in Eckbereichen des Tiegels.

Gemäß einer weiteren Ausführungsform werden durch den Mantelheizer eine Mehrzahl von ebenen Isothermen senkrecht zur Längsrichtung des Tiegels vorgegeben oder aufrechterhalten. Die resultierende ebene Phasengrenze über den gesamten Querschnitt des Tiegels führt zu einer vorteilhaften Reduzierung von Kristallbaufehlern und somit zu einer vorteilhaft geringen Ätzgrubendichte von erfindungsgemäß hergestelltem Siliziumwafern.

Gemäß einer weiteren Ausführungsform ist der Abstand zwischen der Tiegelwand und einer von dem Mantelheizer aufgespannten Ebene über den gesamten Umfang des Tiegels konstant. Durch diese Maßnahme kann eine lokale Überhitzung von Bereichen der Tiegelwand vermieden werden, die ansonsten zu einer Verkrümmung der Phasengrenze führen würde. Insbesondere kann auf diese Weise der Mantelheizer über den gesamten Umfang des Tiegels gleich ausgelegt werden. Gemäß dieser Ausführungsform weist auch der Mantelheizer einen vieleckigen Querschnitt auf, insbesondere gemäß einer bevorzugten Ausführungsform einen rechteckförmigen oder viereckigen Querschnitt, was erheblich von den im Stand der Technik üblichen rotationssymmetrischen Anordnungen abweicht.

Insbesondere bei Tiegeln mit rechteckförmigem oder quadratischem Querschnitt wurden erhöhte Wärmeverluste aufgrund einer je Volumeneinheit größerer abstrahlenden Oberfläche festgestellt. Solche erhöhten Wärmestrahlungsverluste treten in abgemildeter Form auch bei vieleckigen Tiegeln mit einem anderen als rechteckförmigen oder quadratischen Querschnitt auf. Zur Kompensation solcher unerwünschter erhöhter Wärmeverluste ist die Heizleistung des Mantelheizers in Eckbereichen des Tiegels höher oder ist alternativ ein Abstand zwischen der Tiegelwand und dem Mantelheizer in den Eckbereichen des Tiegels kleiner gewählt. Die Heizleistung des Mantelheizers kann dabei in den Eckbereichen stetig oder in einem oder mehreren diskreten Schritten erhöht werden. Alternativ kann der Abstand zwischen der Tiegelwand und dem Mantelheizer stetig oder in einem oder mehreren Schritten verkleinert werden. Insbesondere kann der Mantelheizer in den Eckbereichen stetig gekrümmt ausgebildet sein, mit einem Minimum des Abstands auf einer gedachten Verlängerung einer Linie vom Zentrum des Tiegels zur jeweiligen Ecke des Tiegels, wobei dieser minimale Abstand kleiner ist als in Bereichen der Tiegelwand außerhalb des jeweiligen Eckbereichs.

Gemäß einer weiteren Ausführungsform, insbesondere bei Tiegeln mit rechteckförmigem oder quadratischem Querschnitt umfasst der Mantelheizer um die Seitenflächen des Tiegels angeordnete Heizelemente, die in der Längsrichtung des Tiegels oder senkrecht dazu einen mäanderförmigen Verlauf aufweisen. Auf diese Weise wird eine vergleichsweise gleichmäßige Wärmebeaufschlagung der Tiegelwand erzielt und kann die elektronische Auslegung des Mantelheizers dennoch in einfacher Weise in Entsprechung zu dem Temperaturgradienten in dem Schmelztiegel variiert werden. Dabei wird eine Spaltbreite zwischen den Stegen des mäanderförmigen Verlaufs des Mantelheizers zweckmäßig so gewählt, dass die gut wärmeleitende Graphittiegelwand selbst zu einer ausreichenden Glättung des Temperaturprofils führt. Die Spaltbreite zwischen Stegen des Mantelheizers hängt somit insbesondere auch von der Wärmeleitfähigkeit des Materials oder der Materialien des inneren Tiegels, beispielsweise des Quarztiegels, und des äußeren Stütztiegels, beispielsweise des Graphittiegels ab. Zweckmäßig wird die Spaltbreite dabei so gewählt, dass eine dadurch bedingte Inhomogenität des Temperaturprofils auf der Wand des Tiegels kleiner als eine vorbestimmte Temperaturabweichung ist, die bevorzugt kleiner als etwa 5 K, bevorzugter kleiner als etwa 2K und noch bevorzugten kleiner als etwa 1 K ist.

Gemäß einer ersten Ausführungsform sind die Heizelemente als sich senkrecht zur Längsrichtung erstreckende, rechteckförmige Stege ausgebildet, die in Längsrichtung des Tiegels einen mäanderförmigen Verlauf aufweisen und deren Leiterquerschnitte von dem oberen Ende zu dem unteren Ende des Tiegels hin in mehreren diskreten Schritten zunehmen. Ein solchermaßen ausgebildeter Mantelheizer kann durch einfaches Verbinden vorgeformter Einzelteile, insbesondere aus Graphit, oder Gießen eines geeigneten Heizleitermaterials, in geeigneter geometrischer Ausbildung geformt werden.

Zweckmäßig verlaufen dabei die Stege des Mantelheizers mit mäanderförmigem Verlauf äquidistant und parallel zueinander. Die sich horizontal bzw. senkrecht zur Längsrichtung erstreckenden Stege definieren somit Isothermen, die sich über den gesamten Umfang des Tiegels auf gleichem Höhenniveau erstrecken und somit automatisch zur Ausbildung von Ebenen, horizontalen Phasengrenzen in dem Tiegel führen. Die Verlaufsrichtung der Stege wird dabei an Umkehrbereichen, die den Eckbereichen des Tiegels gegenüberliegen, invertiert. Mit der Geometrie der Umkehrbereiche, insbesondere deren Leiterquerschnitte, steht somit ein einfacher Parameter zur Verfügung, um die thermischen Verhältnisse in den Eckbereichen des Tiegels gezielt vorzugeben.

Insbesondere bei Tiegeln mit rechteckförmigem oder quadratischem Querschnitt umfasst der Mantelheizer um die Seitenflächen des Tiegels angeordnete Heizelemente, die in der Längsrichtung des Tiegels oder senkrecht dazu einen mäanderförmigen Verlauf aufweisen. Auf diese Weise wird eine vergleichsweise gleichmäßige Wärmebeaufschlagung der Tiegelwand erzielt und kann die elektronische Auslegung des Mantelheizers dennoch in einfacher Weise in Entsprechung zu dem Temperaturgradienten in dem Schmelztiegel variiert werden. Dabei wird eine Spaltbreite zwischen den Stegen des mäanderförmigen Verlaufs des Mantelheizers zweckmäßig so gewählt, dass die gut wärmeleitende Graphittiegelwand selbst zu einer ausreichenden Glättung des Temperaturprofils führt. Die Spaltbreite zwischen Stegen des Mantelheizers hängt somit insbesondere auch von der Wärmeleitfähigkeit des Materials des inneren Tiegels(z.B. Quarztiegel) und des äußeren Stütztiegels(z.B. Graphittiegel) ab. Zweckmäßig wird die Spaltbreite dabei so gewählt, dass eine dadurch bedingte Inhomogenität des Temperaturprofils auf der Wand des Tiegels kleiner als eine vorbestimmte Temperaturabweichung ist, die bevorzugt kleiner als etwa 5 K, bevorzugter kleiner als etwa 2K und noch bevorzugten kleiner als etwa 1 K ist.

Insbesondere bei Tiegeln mit rechteckförmigem oder quadratischem Querschnitt können im Bereich der Ecken besondere Vorkehrungen vorgesehen sein, um die angestrebten horizontalen Isothermen auch dort zu gewährleisten. Einfache Umkehrungen in Form von vertikalen Heizstegen bei ansonsten horizontal, mäanderförmig verlaufenden Heizstegen können im Bereich der Diagonalen der Umkehrbereiche ohne weitere Maßnahmen zur Leitungsquerschnittsverringerung zu einem lokal vergrößerten Leitungsquerschnitt und damit zu einer verringerten Heizleistung mit der Folge geringerer Oberflächentemperatur auf dem Heizer führen. Eine Isothermie je Längskoordinate des Tiegels wäre somit nicht zu gewährleisten. An den Ecken käme es dann zu einem unerwünschten Temperaturabfall mit negativen Auswirkungen (Spannungen in den Ecken, dadurch bedingte hohe Defektdichte und Mikrorisse, die zu Ausbeuteverlusten führen). Zur Kompensation solcher Abweichungen von der gewünschten Isothermie je Längskoordinate sind erfindungsgemäß verschiedene Maßnahmen möglich. Der Abstand zwischen der Tiegelwand und dem Mantelheizer in den Eckbereichen des Tiegels kann stetig oder in einem oder mehreren Schritten verkleinert werden, da die Forderung nach Isothermie grundsätzlich nur in der Kristallisationsphase besteht. Insbesondere kann der Mantelheizer in den Eckbereichen stetig gekrümmt ausgebildet sein, mit einem Minimum des Abstands auf einer gedachten Verlängerung einer Linie vom Zentrum des Tiegels zur jeweiligen Ecke des Tiegels, wobei dieser minimale Abstand kleiner ist als in Bereichen der Tiegelwand außerhalb des jeweiligen Eckbereichs.

Gemäß einer bevorzugten weiteren Ausführungsform ist dabei ein Leiterquerschnitt der Stege an den Umkehrbereichen des mäanderförmigen Verlaufs in Diagonalrichtung so verengt, dass er dem Leitungsquerschnitt des Stegs vor oder nach dem jeweiligen Umkehrbereich gleicht. Dies führt zu einer Beibehaltung des elektrischen Widerstands und somit zu einer gleichen Heizleistung bzw. Oberflächentemperatur im Umkehrbereich der Stege wie im Bereich der horizontal verlaufenden Stege.

Gemäß einer weiteren Ausführungsform sind die Verengungen des Leiterquerschnitts an den Umkehrbereichen in kontrollierter Weise durch eine Mehrzahl von Lochungen oder Ausnehmungen in bzw. aus dem Stegmaterial ausgebildet, die quer zum Leiterquerschnitt verteilt angeordnet sind. Durch die Geometrie und die Abmessungen der Lochungen oder Ausnehmungen kann somit der Leiterquerschnitt bzw. der elektrische Widerstand in den Umkehrbereichen an der der Stege angepasst werden. Die Verlaufsrichtung der Lochungen oder Ausnehmungen stellen dabei Varianten dar, die alle zur Vergleichmäßigung der horizontalen Temperaturverteilung über den Umfang des Tiegels in jeder Höhenkoordinate führen können. Bei insgesamt rechteckförmigem Verlauf der Stege können sich die Lochungen bzw. Ausnehmungen insbesondere entlang einer die Eckbereiche der Stege verbindenden Diagonalen erstrecken. Insgesamt ist es zweckmäßig, wenn sich die Mehrzahl von Lochungen bzw. Ausnehmungen spiegelsymmetrisch oder nahezu spiegelsymmetrisch um eine gedachte Spiegelachse im Zentrum des Spalts zwischen zwei zueinander benachbarten Stegen erstrecken.

Gemäß einer zweiten Ausführungsform der vorliegenden Erfindung sind die Heizelemente als sich in der Längsrichtung erstreckende rechteckförmige Stege ausgebildet, deren Leiterquerschnitt von dem oberen Ende zu dem unteren Ende des Tiegels hin kontinuierlich oder in einer Mehrzahl von diskreten Schritten zunimmt. Dabei sind sämtliche sich in Längsrichtung bzw. vertikal erstreckende Stege gleich ausgebildet, so dass in Längsrichtung des Tiegels betrachtet eine Vielzahl von ebenen, horizontalen Isothermen in quasi kontinuierlicher oder diskreter Weise durch den Mantelheizer festgelegt werden. Dabei ist die Spaltbreite zwischen den Stegen, wie vorstehend beschrieben, so gewählt, dass das gut wärmeleitende Material des Tiegels zu einer ausreichenden Vergleichmäßigung des Temperaturprofils zwischen den Stegen des Mantelheizers sorgt. In jedem Fall führen die Bereiche zwischen den Stegen nicht zu Abweichungen vom monotonen und nahezu linear verlaufenden Temperaturanstieg in zunehmender Längskoordinate des Tiegels, wobei hier immer Orte des Zusammentreffens des zu kristallisierenden Materials mit der inneren Tiegelwand betrachtet werden.

Gemäß einer weiteren Ausführungsform ist der Mantelheizer aus Einzelsegmenten gefertigt, die gegebenenfalls, etwa im Falle einer lokalen Beschädigung oder dann, wenn der Mantelheizer anders ausgelegt werden soll, ausgebaut und durch ein anderes Segment ersetzt werden können. Ein solcher modularer Aufbau hat sich insbesondere für Mantelheizer bestehend aus einer Mehrzahl von Heizstegen mit mäanderförmigem Verlauf bewährt. Dabei müssen die Segmente so verbunden werden, dass an den Verbindungsstellen ein ungehinderter Stromfluss gewährleistet ist, was gewisse Kompromisse bei der Wahl der Verbindungsart und der Materialien bedingt. Insbesondere können die Segmente mit Hilfe von Verbindungselementen, wie beispielsweise Keilen oder Stopfen mit einem identischen oder geringfügig größeren Wänneausdehnungskoeffizienten, oder mit Hilfe anderer Form-, Reib- oder Kraftschlusselemente, insbesondere Schrauben oder Nieten, lösbar miteinander verbunden sein. Gemäß einer anderen Ausführungsform können die Segmente auch stoffschlüssig miteinander verbunden sein, beispielsweise durch Löten oder Schweißen.

Gemäß einer weiteren bevorzugten Ausführungsform ist zwischen der Tiegelwand und dem Mantelheizer keine weitere thermische Isolation vorgesehen.

Vorteilhaft ist, dass bei gleichem Querschnitt des Mantelheizers die Tiegelwand näher an den Mantelheizer herangerückt werden kann, also bei gleicher Grundfläche der Kristallisationsanlage Silizium-Ingots mit größerem Querschnitt hergestellt werden können.

Wie vorstehend ausgeführt, betrifft ein weiterer Gesichtspunkt der vorliegenden Erfindung ein Verfahren zur Herstellung von multikristallinem Silizium nach dem Vertical-Gradient-Freeze-Verfahren (VGF-Verfahren) unter Nutzung eines Einzonenmantelheizers, mittels dessen die Temperaturverteilung in dem Tiegel so eingestellt wird, dass die Isotherme der Schmelztemperatur des zu züchtenden Siliziums den Schmelztiegel horizontal schneidet. Durch langsame Abkühlung des gesamten Ofens, verbunden mit einer Verschiebung der vertikalen Temperaturprofils nach oben erfolgt dabei eine gerichtete Erstarrung des Siliziums, mit Verlaufsrichtung der kristallinen Bereiche in vertikaler Richtung.

Zur Minimierung von Kristallbaufehlern ist dabei darauf zu achten, dass ideal kein radialer Wärmefluss auftritt. Während dies herkömmlich dadurch erreicht wird, dass eine möglichst ideale thermische Isolation vorgesehen wird, welche die Mantelfläche des Tiegels umgibt, um einen radialen Wärmeschluss zu unterbinden, wird erfindungsgemäß der Temperaturgradient im Tiegel durch den um den Umfang des Tiegels herum angeordneten Mantelheizer nachgebildet. Erfindungsgemäß braucht somit nur noch ein geringer Aufwand zur thermischen Isolation der aus Tiegel und Heizer bestehenden Anlageneinbauten gegenüber der Außenwand der Kristallisationsanlage und damit gegen die Umgebung betrieben werden, was zu durch die enge Kopplung zu einem schnellen Wärmeübergang führt. Die Steuerungsmöglichkeiten des Prozesses sind durch geringere Zeitverzögerungen daher stark verbessert.

Ein weiterer Gesichtspunkt der vorliegenden Erfindung betrifft die Verwendung einer Kristallisationsanlage, wie vorstehend beschrieben, bzw. eines entsprechenden Kristallisationsverfahrens zur Herstellung von multikristallinem Silizium mittels eines Vertical-Gradient-Freeze-Kristallziehverfahrens (VGF), insbesondere als Ausgangsmaterial für multikristalline Si-Wafer zur Verwendung in der Photovoltaik.

## Figurenübersicht

Nachfolgend wird die Erfindung in beispielhafter Weise und unter Bezugnahme auf die beigefügten Zeichnungen beschrieben werden, woraus sich weitere Merkmale, Vorteile und zu lösende Aufgaben ergeben werden. Es zeigen:

Fig. 1 in einer schematischen Querschnittsdarstellung eine Vorrichtung zur Herstellung von multikristallinem Silizium gemäß der vorliegenden Erfindung;

Fig. 2 in einer schematischen Draufsicht einen Mantelheizer mit einem mäanderförmigen Verlauf der Heizstege;

Fig. 3a in einer schematischen Darstellung Maßnahmen zur Verengung des Leiterquerschnitts gemäß einer ersten Ausführungsform der vorliegenden Erfindung;

Fig. 3b Maßnahmen zur Verengung des Leiterquerschnitts gemäß einer zweiten Ausführungsform der vorliegenden Erfindung;

Fig.3c Maßnahmen zur Verengung des Leiterquerschnitts gemäß einer dritten Ausführungsform der vorliegenden Erfindung;

Fig. 4a-4c in einer schematischen Draufsicht unterschiedliche Verbindungsarten zur Verbindung von Stegen des Mantelheizers gemäß der Fig. 2;

Fig. 4d in einer perspektivischen Ansicht eine weitere Verbindungsart; und

Fig. 5 ein gemessenes Temperaturprofil über eine Verbindungsstelle bei der Verbindungsart gemäß der Fig. 4d.

In den Figuren bezeichnen identische Bezugszeichen identische oder im Wesentlichen gleich wirkende Elemente oder Elementsgruppen.

## Ausführliche Beschreibung von bevorzugten Ausführungsbeispielen

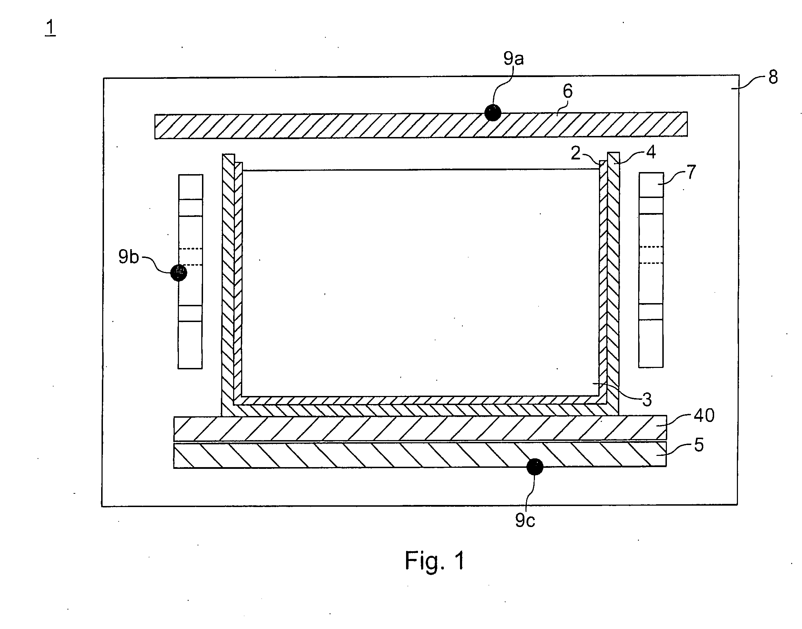

Die Fig. 1 zeigt ein Beispiel für eine Vertical-Gradient-Freeze-Kristallisationsanlage, die einen Tiegel mit viereckigem Querschnitt aufweist. Gemäß der Fig. 1 ist der Tiegel von einem Quarztiegel 2 ausgebildet, der zur Abstützung in einem korrespondierend ausgebildeten Graphitbehälter 4 eng anliegend aufgenommen ist. Das in dem Tiegel 2 aufgenommene Silizium 3 gelangt somit nicht in Anlage zu dem Graphitbehälter 4. Der Tiegel ist aufrecht stehend angeordnet, so dass die Tiegelwände entlang der Richtung der Schwerkraft verlaufen. Oberhalb und unterhalb des Tiegels befindet sich ein Deckelheizer 6 bzw. ein Bodenheizer 5, wobei zwischen dem Tiegel und dem Bodenheizer 5 eine Tiegelaufstellplatte 40, beispielsweise aus Graphit, angeordnet ist, die in der Darstellung nur schematisch angedeutet ist. Dabei ist die eigentliche Halterung des vorgenannten Tiegels so ausgebildet, dass zwischen dem Bodenheizer 5 und der den Tiegel abstützenden Tiegelaufstellplatte 40 ein schmaler Spalt ausgebildet ist. Umgeben wird die Kernzone des Tiegels von einem Mantelheizer 7, der nachfolgend ausführlicher beschrieben werden wird. Bei dem VGF-Kristallisationsverfahren sind alle Heizer 5-7 temperaturgeregelt. Dazu werden die Oberflächentemperaturen der Heizer durch Pyrometer 9a-9c an geeigneter Stelle, wie beispielhaft in der Fig. 1 dargestellt, erfasst und in eine Steuerungseinheit eingegeben, die den durch die Heizer 5-7 fließenden Konstantstrom geeignet steuert bzw. regelt.

Zum Auskristallisieren der Silizium-Schmelze werden der Bodenheizer 5 und der Deckelheizer 6 derart geregelt, dass der Deckelheizer 6 auf einer Temperatur oberhalb der Schmelztemperatur des zu verarbeitenden Siliziums gehalten wird und der Bodenheizer 5 zunächst auf eine Temperatur knapp unterhalb der Schmelztemperatur des zu verarbeitenden Siliziums gebracht wird. Dies führt zunächst zur Auskristallisation am Boden des Tiegels. Da sich der Bodenheizer 5 über die gesamte Fläche des Bodens des Tiegels erstreckt, kristallisiert das Silizium nicht nur im Zentrum sondern am gesamten Boden des Tiegels in Form einer Vielzahl von Kristalliten aus. Anschließend wird die Temperatur eines jeden der drei dargestellten Heizer parallel zu den anderen Heizern heruntergefahren, so dass die Schmelze in dem Tiegel kontinuierlich nach oben erstarren kann, wobei die Phasengrenze zwischen dem schon auskristallisierten und dem noch geschmolzenen Material horizontal, also senkrecht zur Richtung der Schwerkraft, verläuft.

Gemäß der Fig. 1 ist zwischen der Tiegelwand 2, 4 und dem Mantelheizer 7 keine weitere thermische Isolation vorgesehen. Vielmehr wird erfindungsgemäß durch geeignete geometrische Auslegung des Mantelheizers 7, wie nachfolgend ausführlicher beschrieben, dafür gesorgt, dass der von dem Deckelheizer 6 und dem Bodenheizer 5 in dem Tiegel vorgegebene Temperaturgradient durch die von dem Mantelheizer abgegebene Heizleistung unterstützt oder aufrechterhalten wird. Zu diesem Zweck ist die von dem Mantelheizer abgegebene Heizleistung örtlich nicht konstant sondern nimmt in Längsrichtung des Tiegels vom oberen Ende zum unteren Ende hin ab, und zwar in Entsprechung zu dem Temperaturgradienten im Zentrum des Tiegels während der allmählichen Erstarrung der Silizium-Schmelze.

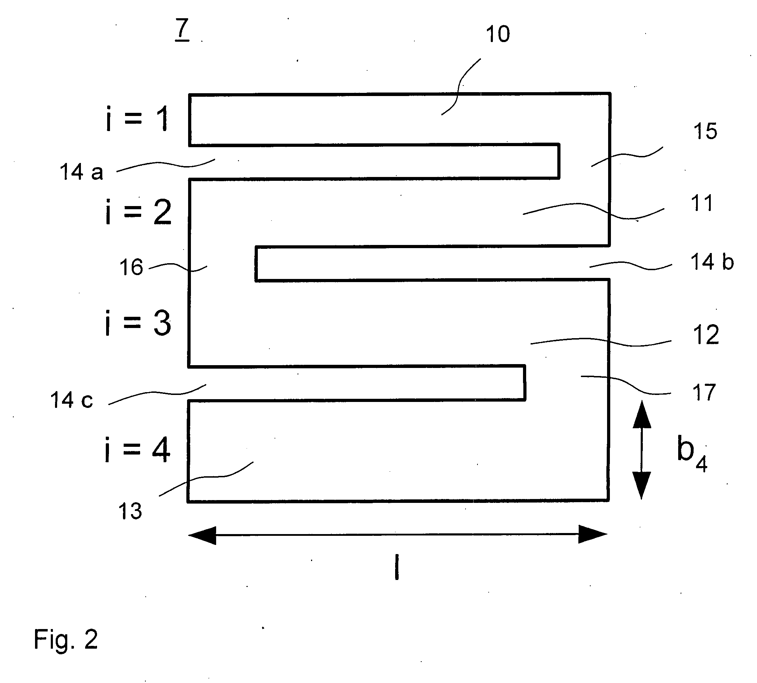

Die Fig. 2 zeigt ein Mantelheizersegment gemäß einer ersten Ausführungsform der vorliegenden Erfindung, der aus einer Mehrzahl von Heizstegen mit rechteckförmigem Profil ausgebildet ist, die in Längsrichtung des Tiegels einen mäanderförmigen Verlauf ausbilden. Genauer gesagt ist jedes Mantelheizersegment gemäß der Fig. 2 unter konstantem Abstand zu einer Tiegelwand angeordnet, so dass die Stege 10-13 sich exakt horizontal, senkrecht zur Längsrichtung des Tiegels, erstrecken. Die Verlaufsrichtung der Stege 10-13 kehrt an den Umkehrbereichen 15-17 um. Gemäß der Fig. 2 nimmt der Querschnitt der Stege 10-13 vom oberen Ende zum unteren Ende des Tiegels hin in diskreten Schritten zu. Die Heizleistung des obersten Stegs 10 ist somit am höchsten und nimmt in diskreten Schritten, wie durch die Leiterquerschnitte der Stege 11, 12 vorgegeben, zu der durch den Querschnitt des untersten Stegs 13 vorgegebenen niedrigsten Heizleistung ab.

Bei einer alternativen Ausführungsform (nicht gezeigt) sind die Breiten der Stege 10-13 konstant, nimmt jedoch deren Dicke, senkrecht zur Zeichenebene der Fig. 2 betrachtet, in diskreten Schritten vom oberen Ende zum unteren Ende des Tiegels hin zu.

Durch einen Mantelheizer, der aus mehreren Mantelheizersegmenten besteht, fließt ein Konstantstrom. Dabei definieren die horizontal verlaufenden Stege 10, 11, 12 und 13 Isothermen, die sich über die gesamte Breite des Tiegels erstrecken. Um den Umfang des Tiegels herum sind unter jeweils gleichen Abständen mehrere solcher Mantelheizer gemäß der Fig. 2 angeordnet, so dass die durch die Stege 10-13 festgelegten Isothennen sich über den gesamten Querschnitt des Tiegels erstrecken, um so ebene, horizontale Isothermenflächen vorzugeben.

Wenngleich in der Fig. 2 dargestellt ist, dass der Mantelheizer 7 insgesamt vier Querstege aufweist, können erfindungsgemäß beliebige andere Anzahlen von Heizstegen verwendet werden. Die optimale Anzahl von Heizstegen ergibt sich aus der gewünschten Vergleichmäßigung des Temperaturprofils im Tiegel und an der Tiegelwand. Zur Auslegung des Mantelheizers geht dabei insbesondere die Breite der Spalte 14a-14c zwischen den Stegen 10-13, der gewählte Abstand des Mantelheizers 7 zur Tiegelwand und die thermischen Eigenschaften der Tiegelwand ein. Der gut wärmeleitende Graphittiegel 4 (vgl. Fig. 1) mit ausreichender Stärke und der darin befindliche Quarztiegel führen dabei zu einer gewissen Glättung des vertikalen Temperaturprofils. Vorstehende Parameter werden so gewählt, dass die Position eines Stegs des Mantelheizers am Temperaturprofil an der Grenzfläche Silizium/seitliche Innenwand des Quarztiegels im Wesentlichen nicht mehr feststellbar ist.

Allgemein gilt bei dem Mantelheizer gemäß der Fig. 2 mit einer Länge der Stege 1 einer Breite der Stege $b_i$ (wobei i den laufenden Index des Stegs bezeichnet) und einer Dicke d (senkrecht zur Zeichenebene der Fig. 2), dass der elektrische Widerstand eines Heizstegs mit dem Index i gegeben ist durch:

$$Ri \sim l/Ai, \text{ wobei}$$

$$Ai = bi \times d.$$

Für die Querschnittflächen gilt dann:

$$A1 < A2 < A3 < A4.$$

Daraus folgt für die Widerstände der Einzelmäander R1 < R2 < R3 < R4.

Somit folgt:

$$T1 > T2 > T3 > T4.$$

Es ergibt sich also in vertikaler Richtung ein Temperaturprofil mit nach oben hin in diskreten Schritten zunehmender Temperatur. Bei Durchströmung des Heizmäanders mit einer konstanten Stromstärke wird in den Stegen mit großem Querschnitt (entsprechend einem geringen elektrischen Widerstand) eine niedrigere Temperatur erzeugt als in den Stegen mit kleinem Querschnitt (entsprechend einem großen Widerstand).

Wie dem Fachmann ohne weiteres ersichtlich sein wird, kann die Variation des stromdurchflossenen Leiterquerschnitts von Steg zu Steg auch durch Variation der Stegdicke d anstelle der Stegbreite b, wie vorstehend beschrieben, erzielt werden.

Bei einem Ausführungsbeispiel gemäß der Fig. 2 werden folgende Flächenverhältnisse eingestellt:

| | |
|---|---|
| A1/A1 | 1 |
| A2/A1 | 1,055 |
| A3/A1 | 1,11 |
| A4/A1 | 1,165 |

Aus diesen Flächenverhältnissen ergeben sich folgende Widerstandsverhältnisse:

| | |
|---|---|
| R1/R1 | 1 |
| R2/R1 | 0,948 |
| R3/R1 | 0,901 |
| R4/R1 | 0,858 |

Wie in der Fig. 2 erkennbar, variiert die Breite des Heizleiters auch in den Umkehrbereichen 15 bis 17 in entsprechender Weise. Die Breite des Umkehrbereichs 15 ist somit kleiner als die Breite des Umkehrbereichs 16, die wiederum kleiner ist als die Breite des Umkehrbereichs 17. Die Variation der Breiten der Umkehrbereiche folgt dem auszubildenden Temperaturprofil.

Betrachtet man die Umkehrbereiche 15-17 des Mantelheizers 7 gemäß der Fig. 2, so treten dort lokale Querschnittsvergrößerungen des stromdurchflossenen Materials auf. Diese würden ohne Gegenmaßnahmen zu einer niedrigen Temperatur an den Eckbereichen des Tiegels führen. Dem wird erfindungsgemäß durch eine gezielte Verengung des Leiterquerschnitts in den Umkehrbereichen entgegengewirkt. Insbesondere können durch eine solche Verengung des Leiterquerschnitts auch erhöhte Wärmeverluste in den Eckbereichen des Tiegels, beispielsweise aufgrund höherer Wärmestrahlungsverluste bedingt durch die je Volumeneinheit größere abstrahlende Fläche, kompensiert werden.

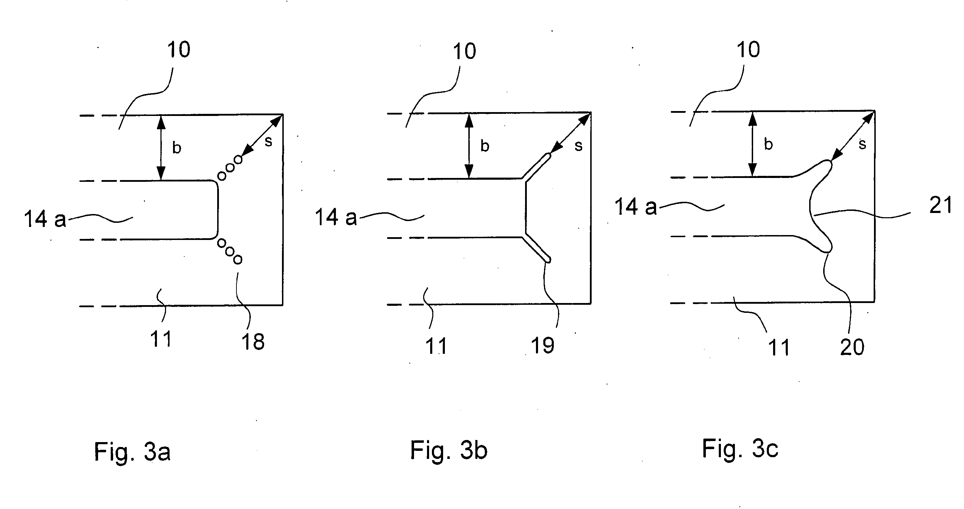

Gemäß der Fig. 3a sind entlang den Diagonalen des jeweiligen Umkehrbereichs eine Mehrzahl von Lochungen oder Ausnehmungen 18 angeordnet, und zwar auf der Diagonalen fluchtend. Insgesamt sind die Lochungen bzw. Ausnehmungen 18 spiegelsymmetrisch zur Mittellinie des Spalts 14a angeordnet. Selbstverständlich können in dem Umkehrbereich auch mehrere solcher Reihen von Lochungen bzw. Ausnehmungen vorgesehen sein. Durch Auslegung und Wahl der Anzahl Lochungen bzw. Ausnehmungen kann das Widerstandsverhältnis zwischen dem sich in horizontaler Richtung erstreckenden Steg 10, 11 und dem zugeordneten Umkehrbereich geeignet eingestellt werden.

Bei der Ausführungsform gemäß der Fig. 3b sind entlang der Diagonalen rechteckförmige Ausnehmungen ausgebildet. Durch Wahl des Verhältnisses s/b kann ein optimales Widerstandsverhältnis eingestellt werden.

Gemäß der Fig. 3c sind entlang der Diagonalen sich verengende Ausnehmungen ausgebildet, wobei zwischen den Ausnehmungen 20 ein konkav einwärts gewölbter Randverlauf ausgebildet ist. Die vorstehenden Ausnehmungen 11, 20 können insbesondere durch Fräsen aus dem Material des Heizleiters ausgebildet werden.

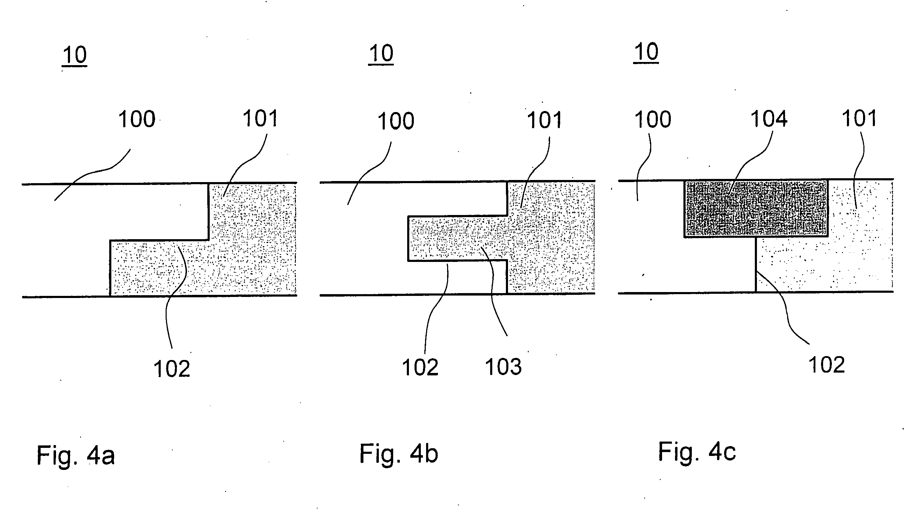

Bevorzugt werden die Stege des Mantelheizers aus Graphit hergestellt. Da erfindungsgemäß Tiegel mit eine Grundfläche von 680 x 680 mm oder noch größere Tiegel verwendet werden, entsprechend große Graphitblöcke zur Herstellung der Stege des Mantelheizers entweder gar nicht verfügbar sind oder nur zu einem vergleichsweise hohen Preis, werden die Stege des Mantelheizersegments gemäß einer weiteren Ausführungsform, wie nachfolgend ausführlich anhand der Fig. 4a bis 4d beschrieben, aus wiederum einer Mehrzahl kleinerer Segmente gebildet. Dabei ist auf einen weitestgehend ungehinderten Stromfluss durch die Verbindungsstellen zwischen den Mantelheizersegmenten als auch zwischen den kleineren Segmenten zu achten. Hierzu werden formschlüssig ineinander eingreifende Verbindungsflächen mit rechtwinkliger Geometrie verwendet.

Gemäß der Fig. 4a sind die Enden der Heizsegmente 100, 101 im Wesentlichen L-förmig ausgebildet, so dass zwischen beiden Segmenten 100, 101 eine gestufte Grenzfläche 102 ausgebildet ist. Gemäß der Fig. 4b ist am Ende des Segments 100 eine zentrale U-förmige Ausnehmung ausgebildet und ist am gegenüberliegenden Ende des Segments 101 ein korrespondierender invers U-förmiger Vorsprung 103 ausgebildet, der in die Ausnehmung des Segments 100 eng anliegend angepasst ist. Somit wird zwischen den Segmenten 100, 101 eine Grenzfläche 102 mit einem zentralen Vorsprung ausgebildet. Gemäß der Fig. 4c ist an den Enden der Segmente 100, 101 eine quaderförmige Ausnehmung ausgebildet, zur Aufnahme eines Verbindungselements 104.

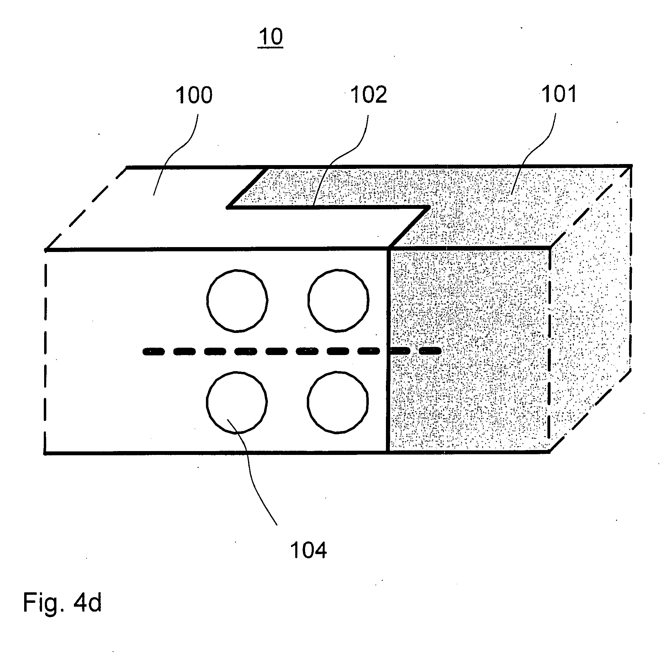

Die Fig. 4d zeigt die Verbindung gemäß der Fig. 4a in einer perspektivischen Draufsicht, wobei die Segmente 100, 101 von zylindrischen Verbindungselementen 104 durchgriffen werden. Die Verbindungselemente 104 können aus dem Material der Segmente 100, 1001 ausgebildet sein. Die Verbindungselemente 104 können form-, reib- oder kraftschlüssig in die Segmente 100, 101 eingreifen. Die Verbindungselemente 104 können alternativ auch aus einem anderen Material mit einem identischen oder geringfügig größeren Wärmeausdehnungskoeffizienten als dem Material der Segmente 100, 101 ausgebildet sein.

**Ausführungsbeispiel 1**

Zwei quaderförmige Heizersegmente aus Graphit wurden in der Art gemäß der Fig. 4d miteinander verbunden und ein Temperaturprofil wurde entlang der gestrichelten Linie gemäß der Fig. 4d ortsaufgelöst aufgenommen. Aus Korrosionsgründen wurden die Messungen in normaler Luftatmosphäre und bei tieferer Temperatur als der späteren Einsatztemperatur unter Stromdurchfluss vorgenommen. Die gemessene Gleichmäßigkeit des Temperaturprofils auf diesem niedrigeren Temperaturniveau ist jedoch vollständig übertragbar auf das spätere höhere Einsatztemperaturniveau.

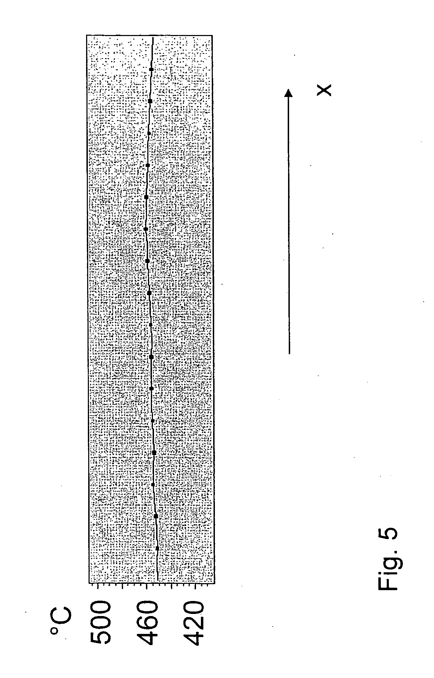

Wie der Fig. 5 entnommen werden kann, sind die Temperaturschwankungen im Verbindungsbereich von der Größenordnung von kleiner als etwa $\pm$ 5° Celsius.

**Ausführungsbeispiel 2**

Es wird zur Herstellung eines multikristallinen Silizium-Ingots der Innenraum eines Schmelztiegels mit einer stückigen oder granularen Silizium-Schüttung gefüllt. Die Vorrichtung gemäß der Fig. 1 wird zur Entfernung von unerwünschtem Luftsauerstoff mit Inertgas, beispielsweise Argon, gespült. Danach kann unter Vakuum oder auch bei Normaldruck durch Anstellen und Hochfahren des Decken-, des Boden- sowie des Mantelheizers das Aufschmelzen des Siliziums beginnen. Nach mehrere Stunden ist eine Temperatur oberhalb der Schmelztemperatur und kleiner als 1550°C erreicht und das Aufschmelzen abgeschlossen. Nunmehr wird der Bodenheizer auf eine definierte Temperatur von mindestens 10°C unter die Schmelztemperatur abgesenkt. Am Boden des Schmelztiegels kommt es nun zur Initiierung des Kristallwachstums. Nach kurzer Zeit stellt sich ein Gleichgewichtstemperaturprofil ein und das initiierte Kristallwachstum kommt zum Erliegen. In diesem Zustand haben Decken- und Bodenheizer den gewünschten Temperaturunterschied welcher gleich dem Temperaturunterschied zwischen oben und unten im Mantelheizer ist. Jetzt wird ein jeder der drei Heizer heruntergefahren und zwar jeder parallel zu den anderen. Es kommt zu einem kolumnaren Wachstum einer Vielzahl von Kristallen. Entsprechend der horizontalen Phasengrenze erfolgt das Wachstum parallel und senkrecht von unten nach oben. Der so erhaltene multikristalline Si-Ingot wird dann auf Raumtemperatur abgekühlt und entnommen. Auf diese Weise wird ein Si-Ingot mit einer quadratischen Grundform von 680 x 680 mm erhalten. Der multikristalline Silizium-Ingot weist über das gesamte Kristallvolumen eine geringe Kristallfehlerdichte auf.

Die segmentierte mäanderförmige Heizergestaltung kann, wie dem Fachmann ohne Weiteres ersichtlich sein wird, auch für die Heizer oberhalb und unterhalb des Tiegels verwendet werden. Eine Variation der stromdurchflossenen Querschnitte erfolgt bei diesen Heizern jedoch zweckmäßig nicht, da Oberseite und Unterseite des Silizium-Ingots möglichst gleichmäßig beheizt werden sollen. Der optional unter dem Tiegelboden vorgesehene Heizer unterstützt das Aufschmelzen von stückigem Silizium mit dem Ziel einer möglichst kurzen Prozesszeit. Während der Kristallisation wird der Heizer am Tiegelboden jedoch grundsätzlich nicht benötigt.

Ein Heizer oberhalb des Tiegels unterstützt ebenfalls die Verkürzung der Prozesszeit beim Aufschmelzen von stückigem Silizium, wenn dieses im Tiegel erfolgt. Während der Kristallisation besteht die Aufgabe des Heizers oberhalb des Tiegels darin, im Zusammenwirken mit dem Mantelheizer das Temperaturniveau im gesamten Tiegel so abzusenken, dass die Kristallisation stets an einer ebenen Phasengrenze erfolgt, und zwar unabhängig davon, in welcher Höhe des Tiegels sie sich gerade befindet. Die Temperaturabsenkung der Heizer wird dabei elektronisch gesteuert und kommt dabei ohne jegliche Tiegelabsenkung aus.

Die Heizergestaltung im Zusammenwirken mit der elektronisch gesteuerten Temperaturabsenkung bewirkt insbesondere die folgenden Vorteile:

➢ Die ebene Phasengrenze in allen Kristallisationsphasen bewirkt ein kolumnares, senkrechtes Wachstum der Si-Körner mit homogenem Gefüge;

➢ Geringe Anzahl von Liniendefekten im Ingot, feststellbar am Si-Wafer anhand einer geringeren Ätzgrubendichte;

➢ Minimierung der Konvektionsströmungen im noch schmelzflüssigen Si oberhalb der Phasengrenze und dadurch Minimierung des Transportes von $Si_3N_4$-Partikeln von der innenbeschichteten Quarztiegelwand in das Innere der Schmelze bzw. Minimierung des Transportes von SiC-Partikeln von der Oberfläche des schmelzflüssigen Si in das Innere der Schmelze, was beides zu verringerten Einschlüssen im Ingot führt; die Ausbeute und der Wirkungsgrad werden durch die vorgenannte Minierung erhöht;

➢ Verhinderung von Spannungen im Eckenbereich des Ingots und dadurch Vermeidung erhöhter Defektkonzentrationen in den Ecken, Vermeidung spannungsbedingter Mikrorisse, die ansonsten in späteren Bearbeitungsschritten zu Ausbeuteverlusten führen würden.

**Bezugszeichenliste**

| | |
|---|---|
| 1 | Kristallisationsanlage |
| 2 | Tiegel |
| 3 | Schmelze |
| 4 | Graphitbehälter |
| 40 | Tiegelaufstellplatte |

| | |
|---|---|
| 5 | Bodenheizer |
| 6 | Deckelheizer |
| 7 | Mantelheizer |
| 8 | Thermische Isolation |
| 9 | Temperaturfühler |
| 10 | Horizontaler Steg |
| 100 | Erstes Segment |
| 101 | Zweites Segment |
| 102 | Grenzfläche |
| 103 | Zentraler Vorsprung |
| 104 | Verbindungselement |
| 11 | Horizontaler Steg |
| 12 | Horizontaler Steg |
| 13 | Horizontaler Steg |
| 14a-c | Spalt |
| 15 | Vertikaler Verbindungssteg |
| 16 | Vertikaler Verbindungssteg |
| 17 | Vertikaler Verbindungssteg |
| 18 | Bohrung/Ausnehmung |
| 19 | Ausnehmung |
| 20 | Ausnehmung |
| 21 | Rand |

**Patentansprüche**

1. Vorrichtung zur Herstellung von ein- oder multikristallinen Materialien nach dem Vertical-Gradient-Freeze-Verfahren (VGF-Verfahren), insbesondere von multikristallinem Silizium, umfassend
einen feststehenden Tiegel (2, 4) mit einem, in Längsrichtung betrachtet, unteren und oberen Ende, der einen vieleckigen Querschnitt, insbesondere einen rechteckförmigen oder quadratischen Querschnitt, aufweist; und
einer Heizeinrichtung (5-7) zum Aufschmelzen des Siliziums; wobei
die Vorrichtung ausgelegt ist, um in dem Tiegel (2, 4) einen Temperaturgradienten in der Längsrichtung auszubilden, und
die Heizeinrichtung ein flächiges Heizelement (7) zur Unterdrückung eines Wärmeflusses senkrecht zur Längsrichtung aufweist, welches flächige Heizelement um den Tiegel (2, 4) herum angeordnet ist und eine Mehrzahl von an Seitenflächen des Tiegels (2, 4) angeordneten Heizelementen (10-13) umfasst, die in der Längsrichtung oder senkrecht dazu einen mäanderförmigen Verlauf aufweisen, **dadurch gekennzeichnet, dass** an Umkehrbereichen (15-17) des mäanderförmigen Verlaufs in Eckbereichen des Tiegels (2, 4) eine durch den elektrischen Widerstand vorgegebene Heizleistung des flächigen Heizelements (7) höher ist oder der Abstand zwischen der Tiegelwand und dem flächigen Heizelement kleiner ist.

2. Vorrichtung nach Anspruch 1, wobei die durch den elektrischen Widerstand vorgegebene Heizleistung des flächigen Heizelements (7) in den Eckbereichen stetig oder in zumindest einem diskreten Schritt erhöht ist oder der Abstand zwischen der Tiegelwand und dem flächigen Heizelement in zumindest einem diskreten Schritt verkleinert ist.

3. Vorrichtung nach einem der vorhergehenden Ansprüche, bei der die Heizelemente als rechteckförmige Stege (10-13) ausgebildet sind, wobei ein Leiterquerschnitt der Stege (10-13) an den Umkehrbereichen (15-17) in Diagonalrichtung so verengt ist, dass er dem Leiterquerschnitt eines zugeordneten Stegs vor oder nach dem jeweiligen Umkehrbereich gleicht.

4. Vorrichtung nach Anspruch 3, bei der die Verengungen des Leiterquerschnitts an den Umkehrbereichen (15-17) durch eine Mehrzahl von Lochungen oder Ausnehmungen in bzw. aus dem Stegmaterial ausgebildet sind, die quer zum Leiterquerschnitt verteilt angeordnet sind.

5. Vorrichtung nach Anspruch 4, wobei die Lochungen oder Ausnehmungen in der Diagonalrichtung fluchtend angeordnet sind.

6. Vorrichtung nach Anspruch 4 oder 5, wobei die Lochungen oder Ausnehmungen spiegelsymmetrisch zu einer Mittellinie eines zwischen zwei benachbarten Heizelementen ausgebildeten Spalts (14a) angeordnet sind.

7. Vorrichtung nach einem der Ansprüche 3 bis 6, bei der sich die Stege senkrecht zur Längsrichtung erstrecken, wobei deren Leiterquerschnitte von dem oberen Ende zu dem unteren Ende hin in diskreten Schritten zunehmen und die Stege (10-13) äquidistant und parallel zueinander verlaufen.

8. Vorrichtung nach einem der Ansprüche 3 bis 6, bei der sich die Stege in der Längsrichtung erstrecken, wobei deren Leiterquerschnitt von dem oberen Ende zu dem unteren Ende hin kontinuierlich oder in einer Mehrzahl diskreter Schritte zunimmt und die Stege (10-13) äquidistant und parallel zueinander verlaufen.

9. Vorrichtung nach einem der vorhergehenden Ansprüche, bei der die Außenkontur des flächigen Heizelements korrespondierend zur Außenkontur des Tiegels ausgebildet ist, sodass ein Abstand zwischen dem flächigen Heizelement und dem Tiegel konstant ist.

10. Vorrichtung nach einem der vorhergehenden Ansprüche, bei der die durch den elektrischen Widerstand vorgegebene Heizleistung des flächigen Heizelements (7) in der Längsrichtung in Entsprechung zu dem Temperaturgradienten im Zentrum des Tiegels (2, 4) abnimmt.

11. Vorrichtung nach einem der vorhergehenden Ansprüche, bei der das flächige Heizelement (7) ausgelegt ist, um eine Mehrzahl von ebenen Isothermen senkrecht zur Längsrichtung vorzugeben oder aufrecht zu erhalten.

12. Vorrichtung nach einem der vorhergehenden Ansprüche, bei der das flächige Heizelement (7) eine Heizzone ausbildet, die so ausgelegt ist, dass eine durch den elektrischen Widerstand des flächigen Heizelements (7) vorgegebene, abgegebene Heizleistung von dem oberen Ende zu dem unteren Ende hin abnimmt, um zur Aufrechterhaltung des in dem Tiegel (2, 4) ausgebildeten Temperaturgradienten zumindest beizutragen.

13. Vorrichtung nach einem der Ansprüche 3 bis 8, bei der die Stege (10-13) eine Mehrzahl von Segmenten (100, 101) aufweisen, die mittels Verbindungselementen (104) lösbar miteinander verbunden sind oder die stoffschlüssig miteinander verbunden sind.

14. Vorrichtung nach einem der vorhergehenden Ansprüche, bei der zwischen der Tiegelwand und dem flächige Heizelement (7) keine thermische Isolation vorgesehen ist.

15. Verfahren zur Herstellung von ein- oder multikristallinen Materialien nach dem Vertical-Gradient-Freeze-Verfahren (VGF-Verfahren), insbesondere von multikristallinem Silizium, in einem feststehenden Tiegel (2, 4) mit einem, in Längsrichtung betrachtet, unteren und oberen Ende, der einen vieleckigen Querschnitt, insbesondere einen rechteckförmigen oder quadratischen Querschnitt, aufweist, wobei eine Heizeinrichtung (5-7) in dem Tiegel einen Temperaturgradienten von dem oberen zu dem unteren Ende ausbildet und wobei ein um den Tiegel herum angeordnetes flächiges Heizelement (7) einen Wärmefluss senkrecht zur Längsrichtung unterdrückt, wobei das flächige Heizelement (7) eine Mehrzahl von an Seitenflächen des Tiegels (2, 4) angeordneten Heizelementen (10-13) umfasst, die in der Längsrichtung oder senkrecht dazu einen mäanderförmigen Verlauf aufweisen, bei welchem Verfahren Wärmeverluste in Eckbereichen des Tiegels (2, 4) dadurch kompensiert werden, dass an Umkehrbereichen (15-17) des mäanderförmigen Verlaufs in Eckbereichen des Tiegels (2, 4) eine Heizleistung des flächigen Heizelements (7) höher ist oder der Abstand zwischen der Tiegelwand und dem flächigen Heizelement kleiner ist.

16. Verfahren nach Anspruch 15, wobei die Heizleistung des flächigen Heizelements (7) in den Eckbereichen stetig oder in zumindest einem diskreten Schritt erhöht ist oder der Abstand zwischen der Tiegelwand und dem flächigen Heizelement in zumindest einem diskreten Schritt verkleinert ist.

17. Verfahren nach Anspruch 15 oder 16, bei dem die Heizelemente als rechteckförmige Stege (10-13) mit einem Leiterquerschnitt bereitgestellt werden, der an den Umkehrbereichen (15-17) in Diagonalrichtung so verengt ist, dass er dem Leiterquerschnitt eines zugeordneten Stegs vor oder nach dem Umkehrbereich gleich.

18. Verfahren nach Anspruch 17, bei dem die Verengungen des Leiterquerschnitts an den Umkehrbereichen (15-17) durch eine Mehrzahl von Lochungen oder Ausnehmungen in bzw. aus dem Stegmaterial ausgebildet werden, die quer zum Leiterquersehnilt verteilt ausgebildet werden.

19. Verfahren nach Anspruch 18, bei dem die Lochungen oder Ausnehmungen in der Diagonalrichtung fluchtend angeordnet werden.

20. Verfahren nach Anspruch 18 oder 19, bei dem die Lochungen oder Ausnehmungen spiegelsymmetrisch zu einer Mittellinie eines zwischen zwei benachbarten Heizelementen ausgebildeten Spalts (14a) angeordnet werden.

21. Verfahren nach einem der Ansprüche 17 bis 20, bei dem die Stege als sich senkrecht zur Längsrichtung erstreckende Stege (10-13) bereitgestellt werden, deren Leiterquerschnitte von dem oberen Ende zu dem unteren Ende hin in diskreten Schritten zunahmen, wobei die Stege (10-13) äquidistant und parallel zueinander verlaufend bereitgestellt werden.

22. Verfahren nach einem der Ansprüche 17 bis 20, bei dem die Stege als sich in der Längsrichtung erstreckende Stege bereitgestellt werden, deren Leiterquerschnitt von dem oberen Ende zu dem unteren Ende hin kontinuierlich oder in einer Mehrzahl von diskreten Schritten zunimmt, wobei die Stege (10-13) äquidistant und parallel zueinander verlaufend bereitgestellt werden.

23. Verfahren nach einem der Ansprüche 15 bis 22, bei dem der Tiegel (2, 4) und das flächige Heizelement (7) so bereitgestellt werden, dass ein Abstand zwischen der Tiegelwand und einer von dem flächigen Heizelement (7) aufgespannten Ebene über den gesamten Umfang des Tiegels (2, 4) konstant ist.

24. Verfahren nach einem der Ansprüche 15 bis 23, bei dem die Heizleistung des flächigen Heizelements (7) in der Längsrichtung in Entsprechung zu dem Temperaturgradienten im Zentrum des Tiegels (2, 4) reduziert wird.

25. Verfahren nach einem der Ansprüche 15 oder 24, bei dem das flächigen Heizelement (7) eine Mehrzahl von ebenen Isothermen senkrecht zur Längsrichtung vorgibt oder aufrechterhält.

26. Verfahren nach einem der Ansprüche 15 bis 25, bei dem die Heizleistung des eine Heizzone ausbildenden flächigen Heizelements von dem oberen Ende zu dem unteren Ende reduziert wird, um zur Aufrechterhaltung des in dem Tiegel (2, 4) ausgebildeten Temperaturgradienten zumindest beizutragen.

27. Verfahren nach einem der Anspruche 16 bis 22, bei dem die Stege (10-13) mit einer Mehrzahl von Segmenten (100, 101) bereitgestellt werden, wobei die Segmente mittels Verbindungselementen (104) lösbar miteinander verbunden werden oder die Segmente stoffschlüssig miteinander verbunden bereitgestellt werden.

28. Verfahren nach einem der Ansprüche 15 bis 27, bei dem zwischen der Tiegelwand und dem flächigen Heizelement (7) keine thermische Isolation vorgesehen wird.

29. Verwendung der Vorrichtung nach einem der Ansprüche 1 bis 14 oder des Verfahrens nach einem der Ansprüche 15 bis 28 zur Herstellung von multikristallinem Silizium mittels eines Vertical-Gradiant-Freeze-Kristallziehverfahrens (VGF), insbesondere als Ausgangsmaterial für photovoltaische Bauelemente.

**Claims**

1. A device for the production of monocrystalline or multicrystalline materials using the vertical-gradient-freeze-method (VGF method), in particular of multicrystalline silicon, comprising
a fixed crucible (2, 4) having a bottom end and a top end, if viewed in the longitudinal direction, which has a polygonal cross section, in particular a rectangular or quadratic cross section; and
a heating device (5-7) for melting the silicon; wherein the device is configured to form a temperature gradient in the longitudinal direction, in the crucible (2, 4), and
the heating device comprises a flat heating element (7) to suppress a heat flow perpendicular to the longitudinal direction, said flat heating element being disposed around the crucible (2, 4) and comprising a plurality of heating elements (10-13) disposed on side faces of the crucible (2, 4) with a meandering course in the longitudinal direction or vertically thereto,

**characterised in that** in inversion zones (15-17) of the meandering course in corner areas of the crucible (2, 4), a heat output of the flat heating element (7) defined by the electric resistance is higher or the distance between the crucible wall and the flat heating element is lower.

2. The device according to claim 1, wherein the heat output of the flat heating element (7) defined by the electric resistance in the corner areas is constant or increased in at least one discrete step or wherein the distance between the crucible wall and the flat heating element is reduced in at least one discrete step.

3. The device to according to any of the preceding claims, wherein the heating elements are embodied as rectangular webs (10-13), wherein a conductor cross section of the webs (10-13) at the inversion zones (15-17) is constricted in a diagonal direction in such a way that it is equal to the conductor cross section of an associated web before or after the respective inversion zone.

4. The device according to claim 3, wherein constrictions of the conductor cross section at the inversion zones (15-17) are formed by a plurality of perforations or recesses in or out of the web material, which are disposed in a transverse distribution relative to the conductor cross section.

5. The device according to claim 4, wherein the perforations or recesses are aligned in the diagonal direction.

6. The device according to claim 4 or 5, wherein the perforations or recesses are disposed mirror-symmetrically to a centre line of a gap (14a) formed between two adjacent heating elements.

7. The device according to any of claims 3 to 6, wherein the webs extend perpendicular to the longitudinal direction, wherein their conductor cross sections increase in discrete steps going from the top end to the bottom end and wherein the webs (10-13) extend equidistantly and parallel to each other.

8. The device according to any of claims 3 to 6, wherein the webs extend in the longitudinal direction and their conductor cross section increases continuously or in a plurality of discrete steps going from the top end to the bottom end and wherein the webs (10-13) extend equidistantly and parallel to each other.

9. The device according to any of the preceding claims, wherein the external contour of the flat heating element is shaped in correspondence with the external contour of the crucible so that a distance between the flat heating element and the crucible is constant.

10. The device according to any of the preceding claims, wherein the heat output of the flat heating element (7) defined by the electric resistance decreases in the longitudinal direction in correspondence with the temperature gradient in the centre of the crucible (2, 4).

11. The device according to any of the preceding claims, wherein the flat heating element (7) is configured to set or maintain a plurality of planar isotherms perpendicular to the longitudinal direction.

12. The device according to any of the preceding claims, wherein the flat heating element (7) forms a heating zone which is configured so that the heat output defined by the electric resistance of the flat heating element (7) decreases going from the top end to the bottom end in order to at least contribute to the temperature gradient formed in the crucible (2, 4).

13. The device according to any of claims 3 to 8, wherein the webs (10-13) comprise a plurality of segments (100, 101), which are connected detachably to each other by means of connecting elements (104) or firmly bonded to each other.

14. The device according to any of the preceding claims, wherein no thermal insulation is provided between the crucible wall and the flat heating element (7).

15. A method for the production of monocrystalline or multicrystalline materials, in particular of multicrystalline silicon, using the vertical-gradient-freeze-method (VGF method) in a fixed crucible (2, 4) having a bottom end and a top end, if viewed in the longitudinal direction, and having a polygonal cross section, in particular a rectangular or quadratic cross section, wherein a heating device (5-7) forms a temperature gradient going from the top end to the bottom end in the crucible and wherein a flat heating element (7) disposed around the crucible suppresses a heat flow perpendicular to the longitudinal direction, said flat heating element (7) comprising a plurality of heating elements (10-13), which are disposed on side faces of the crucible (2, 4) and have a meandering course in the longitudinal direction or perpendicular thereto, in which method heat losses in corner areas of the crucible (2, 4) are compensated by increasing a heat output of the flat heating element (7) or by decreasing the distance between the crucible wall and the flat heating element at inversion zones (15-17) of the meandering course in corner areas of the crucible (2, 4).

16. The method according to claim 15, wherein the heat output of the flat heating element (7) in the corner areas is increased continuously or in at least one discrete step or the distance between the crucible wall and the flat heating element is reduced in at least one discrete step.

17. The method according to claim 15 or 16, wherein the heating elements are provided as rectangular webs (10-13) having a conductor cross section which is constricted at the inversion zones (15-17) in the diagonal direction in such a way that it is equal to the conductor cross section of an associated web before or after the inversion zone.

18. The method according to claim 17, wherein the constrictions of the conductor cross section at the inversion zones (15-17) are formed by a plurality of perforations or recesses in or out of the web material, said perforations or recesses being formed in a transverse distribution relative to the conductor cross section.

19. The method according to claim 18, wherein the perforations or recesses are aligned in the diagonal direction.

20. The method according to claim 18 or 19, wherein the perforations or recesses are disposed mirror-symmetrically to a centre line of a gap (14a) formed between two adjacent heating elements.

21. The method according to any of claims 17 to 20, wherein the webs are provided as webs (10-13) extending perpendicular to the longitudinal direction, whose conductor cross sections increase in discrete steps going from the top end to the bottom end, wherein the webs (10-13) are provided extending equidistantly and parallel to each other.

22. The method according to any of claims 17 to 20, wherein the webs are provided as webs extending in the longitudinal direction, whose conductor cross sections increase continuously or in a plurality of discrete steps going from the top end to the bottom end, wherein the webs (10-13) are provided extending equidistantly and parallel to each other.

23. The method according to any of claims 15 to 22, wherein the crucible (2, 4) and the flat heating element (7) are provided such that a distance between the crucible wall and a plane spanned by the flat heating element (7) is constant over the entire circumference of the crucible (2, 4).

24. The method according to any of claims 15 to 23, wherein the heat output of the flat heating element (7) is reduced in the longitudinal direction in correspondence with the temperature gradient in the centre of the crucible (2, 4).

**25.** The method according to any of claims 15 or 24, wherein the flat heating element (7) sets or maintains a plurality of planar isotherms perpendicular to the longitudinal direction.

**26.** The method according to any of claims 15 to 26, wherein the heat output of the flat heating element forming a heating zone is reduced going from the top end to the bottom end in order to at least contribute to the temperature gradient formed in the crucible (2, 4).

**27.** The method according to any of claims 16 to 22, wherein the webs (10-13) are provided with a plurality of segments (100, 101), wherein the segments are connected detachably to each other by means of connecting elements (104) or the segments are provided firmly bonded to each other.

**28.** The method according to any of claims 15 to 27, wherein no thermal insulation is provided between the crucible wall and the flat heating element (7).

**29.** A use of the device according to any of claims 1 to 14 or of the method according to any of claims 15 to 28 for the production of multicrystalline silicon by means of a vertical-gradient-freeze crystal pulling method (VGF), in particular as a starting material for photovoltaic components.

**Revendications**

**1.** Un dispositif pour la production de matériaux monocristallins ou multicristallins utilisant la méthode de solidification-gradient-vertical (méthode VGF), en particulier de silicium multicristallin, comportant
un creuset fixe (2, 4) ayant une extrémité inférieure et une extrémité supérieure, lorsque présenté suivant une direction longitudinale, lequel présente une section transversale polygonale, en particulier une section transversale rectangulaire ou quadratique ; et
un dispositif de chauffage (5-7) pour fondre le silicium ; dans lequel
le dispositif est configuré de façon à générer un gradient de température suivant la direction longitudinale, au sein du creuset (2, 4) et
le dispositif de chauffage comporte un élément de chauffage plat (7) pour supprimer un flux calorifique perpendiculaire à la direction longitudinale, ledit élément de chauffage plat étant disposé autour du creuset (2, 4) et comportant une pluralité d'éléments de chauffage (10-13) disposés sur des faces latérales du creuset (2, 4) avec une course de méandre suivant une direction longitudinale ou verticale,
**caractérisé en ce que**, dans les zones d'inversion (15-17) de la course de méandre proches des coins du creuset (2, 4), une émission calorique plus élevée est générée par une résistance électrique plus élevée de l'élément de chauffage plat (7) ou la distance entre la paroi du creuset et l'élément de chauffage plat est plus faible.

**2.** Le dispositif selon la revendication 1, dans lequel l'émission de chaleur émise par l'élément de chauffage plat (7) définie par la résistance électrique au sein des coins est constante ou augmentée dans au moins une étape élémentaire ou dans lequel la distance entre la paroi du creuset et l'élément de chauffage plat est réduite au moins pendant une étape élémentaire.

**3.** Le dispositif selon l'une quelconque des revendications précédents, dans lequel les éléments de chauffage sont incorporés en tant que toiles rectangulaires (10-13), dans lequel une section transversale conductrice des toiles (10-13) est comprimée suivant une direction diagonale aux zones d'inversion (15-17) de telle manière qu'elle soit égale à la section transversale du conducteur d'un toile associé avant ou après la zone d'inversion respective.

**4.** Le dispositif selon la revendication 3, dans lequel des constrictions de la section transversale du conducteur sont formées aux zones d'inversion (15-17) d'une pluralité des perforations ou trous à l'intérieur ou hors la toile, lesquels sont disposés suivant une distribution transversale relative à la section transversale conductrice.

**5.** Le dispositif selon la revendication 4, dans lequel les perforations ou trous sont alignés suivant une direction diagonale.

**6.** Le dispositif selon la revendication 4 ou 5, dans lequel les perforations ou trous sont disposés d'une manière symétrique en miroir par rapport à une ligne centrale d'un espace (14a) formé entre deux éléments de chauffage adjacents.

**7.** Le dispositif selon l'une quelconque des revendications 3 à 6, dans lequel les toiles s'étendent perpendiculairement à la direction longitudinale, les sections transversales conductrices augmentant de manière discrète depuis l'extrémité supérieure jusqu'à l'extrémité inférieure et dans lequel les toiles (10-13) s'étendent de manière équidistante et parallèle l'une à l'autre.

**8.** Le dispositif selon l'une quelconque des revendications 3 à 6, dans lequel les toiles s'étendent suivant une direction longitudinale, leurs sections transversales conductrices augmentant de manière continue ou en étapes élémentaires depuis l'extrémité supérieure à l'extrémité inférieure et dans lequel les toiles (10-13) s'étendent d'une manière équidistante et parallèle l'une par rapport à l'autre.

9. Le dispositif selon l'une quelconque des revendications précédents, dans lequel le contour externe de l'élément de chauffage plat présente une forme en correspondance avec le contour externe du creuset de sorte qu'une distance entre l'élément de chauffage plat et le creuset reste constante.

10. Le dispositif selon l'une quelconque des revendications précédents, dans lequel l'émission de chaleur de l'élément de chauffage plat (7) définie par la résistance électrique est moins importante suivant la direction longitudinale en correspondance avec le gradient de température au centre du creuset.

11. Le dispositif selon l'une quelconque des revendications précédentes, dans lequel l'élément de chauffage plat (7) est configuré de manière à établir ou à maintenir une pluralité de plans isothermes perpendiculaires à la direction longitudinale.

12. Le dispositif selon l'une quelconque des revendications précédentes, dans lequel l'élément de chauffage plat (7) forme une zone de chauffage dont la forme est telle que l'émission de chaleur définie par la résistance électrique de l'élément de chauffage plat (7) se réduit depuis l'extrémité supérieure jusqu'à l'extrémité inférieure afin de contribuer au moins au gradient de température formé au sein du creuset (2, 4).

13. Le dispositif selon l'une quelconque des revendications 3 à 8, dans lequel les toiles (10-13) comporte une pluralité de segments (100, 101), lesquels sont reliés d'une manière amovible, l'un par rapport à l'autre, au moyen d'éléments de fixation (104) ou encore en étant fermement collés l'un à l'autre.

14. Le dispositif selon l'une quelconque des revendications précédentes, dans lequel aucune isolation thermique n'est mise en place entre la paroi du creuset et l'élément de chauffage plat (7).

15. Une méthode pour la production des matériaux monocristallins ou multicristallins, en particulier de silicium multicristallin, utilisant la méthode de solidification-gradient-vertical (méthode VGF) au sein d'un creuset fixe (2, 4) ayant une extrémité inférieure et une extrémité supérieure, lorsque présenté suivant une direction longitudinale, et ayant une section transversale polygonale, en particulier une section transversale rectangulaire ou quadratique, dans lequel un dispositif de chauffage (5-7) forme un gradient de température allant par l'extrémité supérieure jusqu'à l'extrémité inférieure au sein du creuset et dans lequel un élément de chauffage plat (7) disposé autour du creuset supprime un flux calorifique perpendiculaire à la direction longitudinale, ledit élément de chauffage plat (7) comportant une pluralité d'éléments de chauffage (10-13), lesquels sont disposés sur des faces latéraux du creuset (2, 4) et présente une course de méandre suivant une direction longitudinale ou verticale,
dans laquelle les pertes de chaleur de la méthode au sein des coins du creuset (2, 4) sont compensées par un accroissement d'une émission de chaleur générée par l'élément de chauffage plat (7) ou par une réduction de la distance entre la paroi du creuset et l'élément de chauffage plat aux zones d'inversion (15-17) de la course de méandre au sein des coins du creuset (2, 4).

16. La méthode selon la revendication 15, dans laquelle l'émission de chaleur émise par l'élément de chauffage plat (7) dans les coins augmente de manière continue ou au moins par une étape élémentaireou dans laquelle la distance entre la paroi du creuset et l'élément de chauffage plat est réduite en au moins une étape élémentaire.

17. La méthode selon la revendication 15 ou 16, dans laquelle les éléments de chauffage sont fournies en tant que toiles rectangulaires (10-13), ayant une section transversale conductrice comprimé aux zones d'inversion (15-17) au sein d'une direction diagonale de telle manière qu'elle soit égale à la section transversale conductrice d'une toile associé avant ou après la zone d'inversion.

18. La méthode selon la revendication 17, dans laquelle les constrictions de la section transversale conductrice sont formés aux zones d'inversion (15-17) d'une pluralité des perforations ou orifices dans et hors la toile, lesdits perforations ou trous étant formés au sein d'une distribution transversale relative à la section transversale conductrice.

19. La méthode selon la revendication 18, dans laquelle les perforations ou orifices sont alignés suivant unedirection diagonale.

20. La méthode selon la revendication 18 ou 19, dans laquelle les perforations ou orifices sont disposés d'une manière miroir-symétrique à une ligne centrale d'un espace (14a) formé entre deux éléments de chauffage adjacents.

21. La méthode selon l'une quelconque des revendications 17 à 20, dans laquelle les toiles se présentent sous la forme de toiles (10-13) s'étendant de manière perpendiculaire suivant la direction longitudinale, dont les sections transversales conductrices s'accroissent en des étapes élémentaires depuis l'extrémité supérieure jusqu'à l'extrémité inférieure, les toiles (10-13) s'étendant de manière équidistante et parallèle l'une par rapport à l'autre.

22. La méthode selon l'une quelconque des revendications 17 à 20, dans laquele les toiles se présentent en s'étendant suivant suivant la direction longitudinale, dont les sections transversales conductrices s'accroissent de manière constante ou en une pluralité d'étapes élémentaire, depuis l'extrémité supérieure jusqu'à l'extrémité inférieure, les toiles (10-13) s'étendant de manière équidistante et parallèle l'une par rapport à l'autre.

23. La méthode selon l'une quelconque des revendications 15 à 22, dans laquelle le creuset (2, 4) et l'élément de chauffage plat (7) sont fournies de telle manière qu' une distance entre la paroi du creuset et un plan porté par l'élément de chauffage plat (7) est constant sur toute la circonférence du creuset (2, 4).

24. La méthode selon l'une quelconque des revendications 15 à 23, dans laquelle l' émission de chaleur émise par l'élément de chauffage plat (7) est moins importante suivant la direction longitudinale en correspondance avec le gradient de température au centre du creuset (2, 4).

25. La méthode selon l'une quelconque des revendications 15 ou 24, dans laquelle l' élément de chauffage plat (7) établit ou maintient une pluralité de plans isothermes perpendiculaires à la direction longitudinale.

26. La méthode selon l'une quelconque des revendications 15 à 26, dans laquelle l'émission de chaleur émise par l'élément de chauffage plat (7) formant une zone de chauffage se réduisant depuis l'extrémité supérieure jusqu'à l'extrémité inférieure dans le but de contribuer au gradient de température formé au sein du creuset (2, 4).

27. La méthode selon l'une quelconque des revendications 16 à 22, dans laquelle les toiles (10-13) sont fournies avec une pluralité de segments (100, 101), les segments étant fixés d' une manière amovible l'un par rapport à l'autre au moyen d'éléments de connexion (104) ou les segments sont fournies fermement encollés l' un par rapport à l'autre.

28. La méthode selon l'une quelconque des revendications 15 à 27, dans laquelle aucune isolation thermique n'est mise en place entre le mur de creuset et l'élément de chauffage plat (7).

29. Une utilisation du dispositif selon l'une quelconque des revendications 1 à 14 ou de la méthode selon l'une quelconque des revendications 15 à 28 pour la production de silicium multicristallin au moyen d' une méthode de solidification-gradient-vertical (méthode VGF), en particulier comme matériau de base pour des composants photovoltaïques.

Fig. 1

Fig. 2

EP 1 857 574 B1

Fig. 3a   Fig. 3b   Fig. 3c

Fig. 4a

Fig. 4b

Fig. 4c

EP 1 857 574 B1

10

100    102    101

104

Fig. 4d

Fig. 5

**EP 1 857 574 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 4256530 A
- EP 0631832 A
- EP 0996516 A
- DE 19855061
- WO 0164975 A2

- EP 1147248 B1
- DE 10239104 A1
- JP 2004299968 A
- JP 5043385 A
- EP 1072696 A1